(19) **Europäisches Patentamt / European Patent Office / Office européen des brevets**

(11) **EP 4 206 710 B1**

(12) **FASCICULE DE BREVET EUROPEEN**

(45) Date de publication et mention de la délivrance du brevet:
**28.08.2024 Bulletin 2024/35**

(21) Numéro de dépôt: **22216654.8**

(22) Date de dépôt: **23.12.2022**

(51) Classification Internationale des Brevets (IPC):
**G01R 31/3842** (2019.01)　　**G01R 31/388** (2019.01)
**G01R 31/392** (2019.01)

(52) Classification Coopérative des Brevets (CPC):
**G01R 31/392; G01R 31/3842; G01R 31/388**

(54) **DÉTERMINATION DE L'ÉTAT DE SANTÉ D'UN ACCUMULATEUR ÉLECTRIQUE PAR CONVERSION**

**BESTIMMUNG DES GESUNDHEITSZUSTANDES EINES ELEKTRISCHEN AKKUMULATORS DURCH UMWANDLUNG**

**DETERMINING THE STATE OF HEALTH OF AN ELECTRICAL ACCUMULATOR BY CONVERSION**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **28.12.2021 FR 2114597**

(43) Date de publication de la demande:
**05.07.2023 Bulletin 2023/27**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **KAROUI HENCHIRI, Fathia**
**38054 GRENOBLE cedex 09 (FR)**
• **KLEIN, Jean-Marie**
**38054 GRENOBLE cedex 09 (FR)**
• **MONTARU, Maxime**
**38054 GRENOBLE cedex 09 (FR)**

(74) Mandataire: **INNOV-GROUP**
**310, avenue Berthelot**
**69372 Lyon Cedex 08 (FR)**

(56) Documents cités:
EP-A1- 3 839 535　　WO-A1-2015/086753
CN-A- 107 632 265　　CN-A- 108 957 352
DE-A1- 102015 205 171　　US-A1- 2015 260 795
US-A1- 2021 072 322　　US-A1- 2021 234 387

• HUANG JUNHAN ET AL: "A Novel Autoregressive Rainflow-Integrated Moving Average Modeling Method for the Accurate State of Health Prediction of Lithium-Ion Batteries", PROCESSES, vol. 9, no. 5, 30 April 2021 (2021-04-30), CH, pages 795, XP055952319, ISSN: 2227-9717, DOI: 10.3390/pr9050795
• HUANG JUNHAN ET AL: "An Improved Rainflow Algorithm Combined with Linear Criterion for the Accurate Li-ion Battery Residual Life Prediction", vol. 16, 31 May 2021 (2021-05-31), Serbia, XP055952327, ISSN: 1452-3981, Retrieved from the Internet <URL:http://www.electrochemsci.org/papers/vol16/21075.pdf> [retrieved on 20230524], DOI: 10.20964/2021.07.29

**EP 4 206 710 B1**

## Description

DOMAINE TECHNIQUE

L'invention concerne le domaine des accumulateurs électriques, tels que les accumulateurs électrochimiques, et vise plus particulièrement les techniques permettant de déterminer un indicateur représentatif du vieillissement d'un accumulateur électrique.

ART ANTÉRIEUR

Pour la gestion d'un accumulateur électrique en général, et la gestion de ses cycles de charge et de décharge, il peut être avantageux, voire nécessaire, de disposer d'un indicateur représentatif du vieillissement de l'accumulateur électrique. L'indicateur couramment employé est un paramètre dénommé « état de santé » (SOH pour « State of Health », en anglais) qui est généralement calculé en divisant la capacité de l'accumulateur à l'instant considéré, par la capacité nominale de l'accumulateur. En vieillissant, l'accumulateur perd de sa capacité et cette perte est quantifiée par l'indicateur d'état de santé, qui indique que la capacité actuelle de l'accumulateur correspond à un certain pourcentage de sa capacité nominale, notamment de sa capacité à l'état neuf, ou de sa capacité telle que communiquée par le fabricant.

Les accumulateurs électriques sont généralement associés à un système de gestion de batterie (BMS pour « Battery Management System », en anglais) permettant le contrôle des cycles de charge et de décharge ainsi que de multiples opérations visant à allonger la durée de vie de l'accumulateur. Les systèmes de gestion de batterie actuels nécessitent un plus grand nombre de paramètres en entrée, avec des précisions plus fines, afin de procéder à des opérations avancées de gestion de batterie.

Les techniques connues de détermination de l'état de santé d'une cellule de batterie passent généralement par une mesure de la capacité de chaque cellule de l'accumulateur électrique. Pour cela, chaque cellule est complètement déchargée puis complètement rechargée, ou complètement rechargée puis complètement déchargée. Lors de la recharge complète ou de décharge complète, la quantité de charges accumulée dans la cellule ou extraite de la cellule peut être mesurée par comptage coulométrique, ce qui revient à mesurer la capacité réelle de la cellule. Connaissant la capacité réelle de la cellule, le système de gestion de batterie peut ensuite déterminer l'état de santé de la cellule en divisant cette capacité réelle par la capacité nominale de la cellule. Un inconvénient de ces techniques de détermination de l'état de santé est qu'elles nécessitent la mise en oeuvre d'une décharge complète de la cellule suivie d'une recharge complète, ou d'une recharge complète suivie d'une décharge complète, ce qui est relativement contraignant. Elle est aussi difficilement applicable au cas d'accumulateurs plus complexes, comportant de nombreuses cellules raccordées selon différents sous-ensembles, et pour lesquels les mesure à l'échelle de la cellule ne sont pas disponibles.

La demande de brevet DE102019111976 décrit un procédé pour déterminer la capacité d'une batterie en utilisant une charge ou décharge partielle. Le procédé comprend la détermination d'une première tension de repos à un premier état de charge de la batterie, la détermination d'une seconde tension de repos à un second état de charge de la batterie, la détermination d'une quantité de décharge entre le premier état de charge et le second état de charge, la détermination d'un état de vieillissement de la batterie et la détermination d'une quantité charge de référence sur la base de la première tension de repos, de la seconde tension de repos et d'une caractéristique de tension de repos de référence. Dans ce cas, la courbe caractéristique de tension à vide de référence dépend de l'état de vieillissement. Le procédé comprend également la détermination de la capacité de la batterie sur la base d'une comparaison entre le taux de décharge et le taux de décharge de référence. Ce procédé nécessite au préalable de caractériser la batterie pour obtenir une caractéristique de tension à vide à différents états de vieillissement. Ceci est coûteux, fastidieux et n'est pas applicable aux ensembles complexes d'accumulateurs pour lesquels seules sont disponibles les spécifications et les mesures à l'échelle de cet ensemble. De plus, le procédé en question estime un vieillissement qui ne prend en compte que l'évolution de la capacité en courant électrique.

La demande de brevet US2008/0150491 décrit une méthode permettant d'estimer la capacité réelle d'une cellule d'accumulateur à partir d'une recharge partielle de la cellule. La variation d'état de charge de la cellule nécessaire pour obtenir une estimation fiable de sa capacité réelle reste toutefois relativement élevée, ce qui peut poser problème dans certaines applications.

La demande de brevet FR3018608 pallie à ce problème en utilisant des évolutions d'états de charge plus faibles. Cette méthode n'est cependant pas applicable aux accumulateurs pour lesquels l'opération de charge ne contient pas de phase à tension constante.

Les publications scientifiques suivantes décrivent l'application de la méthode de comptage rainflow dans le domaine de la charge batterie:

- Huang et al. « A Novel Autoregressive Rainflow-Integrated Moving Average Modeling Method for the Accurate State of Health Prédiction of Lithium-Ion Batteries. » Processes 2021, 9, 795. https://doi.org/10.3390/pr9050795 ;
- Huang et al. « An Improved Rainflow Algorithm Combined with Linear Criterion for the Accurate Li-ion Battery Residual Life » J. Electrochem. Sci., 16 (2021) Article ID: 21075, doi: 10.20964/2021.07.29

La demande de brevet EP3839535A1 divulgue un procédé de détermination d'un vieillissement d'une batterie ayant un état de charge variable au sein d'une fenêtre de cyclage formant une partie d'un domaine nominal de fonctionnement.

EXPOSÉ DE L'INVENTION

L'invention a pour but d'améliorer les procédés de l'art antérieur, dans la détermination d'un indicateur d'état de santé d'un accumulateur électrique.

À cet effet, l'invention vise un procédé de détermination d'un indicateur d'état de santé d'un accumulateur électrique, comportant les étapes suivantes :

- déterminer la capacité nominale en énergie de l'accumulateur électrique ;
- acquérir des mesures de paramètres représentatifs de la tension aux bornes de l'accumulateur électrique, du courant délivré par l'accumulateur électrique, et de l'état de charge de l'accumulateur électrique, cette acquisition étant réalisée sur une période de mesure comportant un ensemble d'opérations de charge et de décharge de l'accumulateur électrique ;
- a) convertir l'ensemble d'opérations de charge et de décharge de la période de mesure en un ensemble équivalent de cycles reconstitués symétriques, chaque cycle reconstitué symétrique comportant une opération de charge et une opération de décharge de même amplitude d'état de charge ;

- b) sélectionner les cycles reconstitués symétriques dont l'amplitude d'état de charge est supérieure à une valeur prédéterminée ;
- c) pour chaque cycle reconstitué symétrique sélectionné : déterminer le taux d'énergie fournie par l'accumulateur électrique lors de la phase de décharge, par unité d'amplitude d'état de charge de l'accumulateur électrique ; et déterminer une valeur d'énergie totale équivalente pour une charge complète de l'accumulateur électrique ;
- d) déterminer une valeur moyenne à partir des valeurs d'énergie totale équivalente relatives à une pluralité de cycles reconstitués symétriques sélectionnés, et déterminer l'indicateur d'état de santé de l'accumulateur électrique en divisant cette valeur moyenne par la valeur de la capacité nominale en énergie de l'accumulateur électrique.

Selon un autre objet, l'invention vise un système de gestion d'un stockage d'énergie électrique, tel que des batteries, configuré pour mettre en oeuvre le procédé décrit.

Selon un autre objet, l'invention vise un produit programme d'ordinateur comprenant des instructions qui conduisent un système de gestion de stockage d'énergie électrique à exécuter les étapes du procédé décrit.

Le procédé selon l'invention détermine l'état de santé de l'accumulateur directement à partir des données disponibles et notamment des données disponibles dans un système de gestion de batterie classique, quel que soit l'échelle à laquelle ces données sont produites. En effet, un accumulateur électrique peut être constitué d'une ou plusieurs cellules élémentaires, éventuellement reliées entre elles selon différents niveaux de complexité, de façon à obtenir un générateur électrique de tension et de capacité désirée. Notamment, un accumulateur électrique peut être :

- une simple cellule élémentaire ;
- un module fait d'un ensemble de ces cellules élémentaires reliées ;
- un rack constitué d'un ensemble de modules;
- un conteneur constitué d'un ensemble de racks déconnectables ;
- un ensemble de conteneurs formant une centrale de stockage.

Quelle que soit l'échelle considérée pour un tel accumulateur électrique, le procédé selon l'invention détermine l'état de santé de l'accumulateur à son échelle, sans nécessiter de mesures au niveau des éventuels sous-ensembles composant l'accumulateur. Le procédé selon l'invention s'applique à tout accumulateur associé à des moyens électroniques permettant de réaliser les mesures de tension, de courant et d'état de charge nécessaires. Les systèmes de gestion de batterie classiques sont généralement capables de fournir ces données.

Le procédé selon l'invention ne requiert pas d'opération spécifique telle qu'une recharge complète ou une décharge complète. Aucune intrusion n'est nécessaire dans le fonctionnement de la batterie, la détermination de l'état de santé étant réalisée avec les données classiquement disponibles, de manière totalement transparente sur les cycles de charge et de décharge.

L'invention permet une estimation de la dégradation de l'état de santé des accumulateurs en termes d'évolution de l'énergie disponible, ce qui intègre en même temps l'évolution de la capacité de l'accumulateur et l'évolution de sa résistance, sans nécessiter de calcul individuel de ces grandeurs.

Notamment, l'invention permet la mise en place d'une maintenance prédictive basée sur une indication fiable et précise de l'évolution de la capacité de l'accumulateur à stocker de l'énergie.

De même, une gestion fine de la charge de l'accumulateur, en charge ou en décharge, est permise par l'invention. Il est par exemple possible de déterminer avec une meilleure précision le moment précis où la charge de la batterie peut être stoppée (dès lors que la batterie a fait son plein en termes d'énergie). Il est aussi possible de déterminer quelle est la charge à appliquer à l'accumulateur pour disposer en sortie d'une quantité d'énergie déterminée. Une telle gestion affinée de la charge et décharge de l'accumulateur contribue de manière significative à l'augmentation de la durée de vie des accumulateurs.

Le procédé selon l'invention peut comporter les caractéristiques additionnelles suivantes, seules ou en combinaison :

- à l'étape a), la conversion en cycles reconstitués symétriques est réalisée en associant par paires les minima croissants et les maxima décroissants des opérations de charge et de décharge de la période de mesure ;

- à l'étape a), la conversion est réalisée par application de la méthode de comptage rainflow ;

- à l'étape c), le taux d'énergie fournie par l'accumulateur électrique lors de la phase de décharge, par unité d'amplitude d'état de charge de l'accumulateur électrique, est déterminé en divisant l'énergie déchargée lors de l'opération de décharge du cycle reconstitué symétrique sélectionné, par l'amplitude de charge du cycle reconstitué symétrique sélectionné ;

- à l'étape c), la valeur d'énergie totale équivalente d'un cycle reconstitué symétrique sélectionné est déterminée par la formule suivante :

$$E_{idx} = \frac{DW\,h_{idx}}{SOC_{idis} - SOC_{fdis}} \times 100$$

dans laquelle :

   $E_{idx}$ est l'énergie totale équivalente du cycle reconstitué symétrique sélectionné ;
   $DW\,h_{idx}$ est l'intégrale de la puissance déchargée lors de l'opération de décharge du cycle reconstitué symétrique sélectionné ;
   $SOC_{idis}$ est l'état de charge initial lors de l'opération de décharge du cycle reconstitué symétrique sélectionné ;
   $SOC_{fdis}$ est l'état de charge final lors de l'opération de décharge du cycle reconstitué symétrique sélectionné ;

- la valeur de l'énergie totale équivalente pour chaque cycle reconstitué symétrique est divisée par un nombre de sous-ensembles déconnectables qui constituent l'accumulateur électrique ;

- à l'étape b), les cycles reconstitués symétriques sélectionnés sont ceux dont l'amplitude de variation de l'état de charge ou de la tension est supérieure à une valeur prédéterminée ;

- à l'étape b), ladite valeur prédéterminée est égale à 10 % ;

- à l'étape d), ladite valeur moyenne est déterminée en calculant une moyenne olympique des valeurs d'énergie totale équivalente ;

- à l'étape d), ladite valeur moyenne est une moyenne glissante sur une pluralité de cycles reconstitués symétriques sélectionnés dont la valeur correspondante d'énergie totale équivalente est située dans un intervalle entre un seuil minimal prédéterminé et un seuil maximal prédéterminé ;

- à l'étape d), lesdites valeurs d'énergie totale équivalente relatives à chaque cycle reconstitué symétrique sélectionné comprennent un nombre de valeurs supérieur à une valeur minimale prédéterminée ;

- ladite valeur minimale prédéterminée est de 10 ;

- la capacité nominale en énergie de l'accumulateur électrique est présente en mémoire dans un système de gestion de batterie connecté à l'accumulateur électrique ;

- la capacité nominale en énergie de l'accumulateur électrique est déterminée par mesure lors d'un premier cycle de charge et de décharge complètes, à la mise en service de l'accumulateur électrique ;

- lesdites mesures de paramètres représentatifs de la tension aux bornes de l'accumulateur électrique, du courant délivré par l'accumulateur électrique, et de l'état de charge de l'accumulateur électrique, sont réalisées par un système de gestion de batterie connecté à l'accumulateur électrique.

PRÉSENTATION DES FIGURES

D'autres caractéristiques et avantages de l'invention ressortiront de la description non limitative qui suit, en référence aux dessins annexés dans lesquels :

- la figure 1 illustre un exemple simplifié d'ensembles de cycles de charge et de décharge d'un accumulateur électrique ;

- la figure 2 illustre un ensemble équivalent de cycles reconstitués de l'ensemble de cycles de la figure 1 ;

- la figure 3 illustre un premier exemple réel d'ensembles de cycles de charge et de décharge d'un accumulateur électrique ;

- la figure 4 illustre un deuxième exemple réel d'ensembles de cycles de charge et de décharge d'un accumulateur électrique ;

- la figure 5 est un organigramme illustrant une partie du procédé selon l'invention ;

- la figure 6 est une première illustration des valeurs obtenues par le procédé selon l'invention ;

- la figure 7 est une deuxième illustration des valeurs obtenues par le procédé selon l'invention.

DESCRIPTION DÉTAILLÉE

Le procédé selon l'invention vise à déterminer l'état de santé d'un accumulateur électrique. L'accumulateur peut-être tout accumulateur doté d'un système de gestion de batterie permettant de fournir la tension, le courant, et l'état de charge de l'accumulateur. L'état de charge (SOC pour « State of Charge », en anglais) est un indicateur donnant le rapport entre la charge actuelle de l'accumulateur et sa capacité totale actuelle. Ces données sont bien connues dans le domaine de la gestion des batteries et sont de préférence directement délivrées par le système de gestion de batterie. Le procédé selon l'invention lui-même peut être mis en en oeuvre par le système de gestion de batterie ou par un système de gestion de l'énergie globale à l'échelle de la centrale électrique nommé EMS (de l'anglais Energy Management System).

En plus de ces données, la mise en oeuvre du procédé nécessite la connaissance de la capacité nominale en énergie de l'accumulateur. Cette valeur correspond à l'énergie totale que l'accumulateur peut contenir à pleine charge et avant tout vieillissement. La capacité nominale en énergie peut être une donnée du constructeur de l'accumulateur, et être mise en mémoire dans le système de gestion de batterie. La capacité nominale en énergie peut aussi être calculée par le système de gestion de batterie ou mesurée lors d'une première utilisation durant une phase de décharge complète, en mesurant en continu la tension et l'intensité, pour obtenir une valeur d'énergie (exprimée généralement en Wh).

L'accumulateur électrique peut être tout accumulateur, quelle que soit son échelle, associé à un système de gestion de batterie, notamment une cellule élémentaire, une batterie, un module, un rack, un conteneur, une centrale de stockage.

Dans le présent exemple, l'accumulateur électrique est un conteneur formé de plusieurs racks déconnectables. Dans cette mise en oeuvre particulière du procédé, ce dernier nécessite également un indicateur relatif au nombre de racks présents à chaque instant dans le conteneur formant le système de stockage de l'énergie par batterie (BESS de l'anglais Battery Energy Storage System). Cette information peut également être fournie par le système de gestion de batterie.

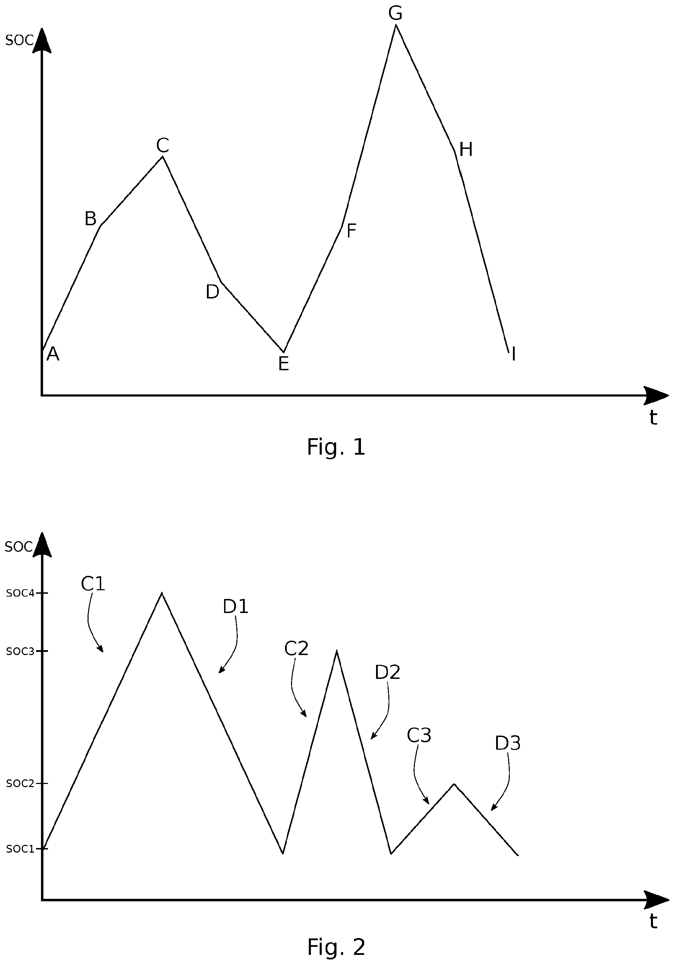

Le procédé de détermination de l'état de santé de l'accumulateur prend place dans une fenêtre temporelle d'acquisition dénommée « période de mesure ». La figure 1 illustre un exemple simple d'évolution de l'état de charge SOC de l'accumulateur électrique en fonction du temps t, sur la période de mesure PM. La période de mesure PM comporte un ensemble d'opérations de charge et de décharge de l'accumulateur, toutes les données évoquées de tension, courant, et état de charge de l'accumulateur, ayant été relevées durant cette période de mesure PM. La période de mesure PM peut être statique ou bien glissante, c'est-à-dire qu'elle s'actualise au fur et à mesure.

Une première étape du procédé consiste à convertir l'ensemble d'opérations de charge et de décharge qui ont lieu sur l'accumulateur durant la période de mesure PM en un ensemble équivalent de cycles. Un cycle comporte une opération de charge et une opération de décharge. Les cycles résultants de cette conversion sont dits « reconstitués » car ils sont issus d'une réorganisation, avec d'éventuelles approximations, de cycles réels de la figure 1.

Bien qu'il soit ici pris à titre d'exemple la reconstitution de cycles de charges/décharges, avec pour but principal d'identifier des cycles de décharge servant de base à l'analyse, toute autre méthode permettant d'identifier des opérations de décharge au sein d'une période de mesure est applicable à l'invention.

La figure 2 illustre les principes sur lesquels se base une telle conversion. La figure 1 étant relative à un exemple théorique de vie de l'accumulateur, très simplifié pour des fins didactiques, la figure 2 illustre un exemple de l'ensemble équivalent de cycles reconstitués.

Dans cet exemple illustratif, l'accumulateur subit successivement (voir figure 1) :

- une opération de charge conduisant à une augmentation de l'état de charge selon une première pente (segment AB) puis selon une seconde pente (segment BC) ;
- une opération de décharge conduisant à une diminution de l'état de charge suivant une première pente (segment CD) puis selon une deuxième pente (segment DE) ;
- une deuxième opération de charge conduisant à une augmentation de l'état de charge selon une première pente (segment EF) puis selon une seconde pente (segment FG) ;
- une deuxième opération de décharge conduisant à une diminution de l'état de charge suivant une première pente (segment GH) puis selon une seconde pente (segment HI).

L'ensemble de cycles de charge et décharge réels de la figure 1 est, selon cet exemple trivial, converti dans l'ensemble équivalent de cycles reconstitués de la figure 2, de la manière suivante :

- les segments AB et EF sont mis bout à bout pour former l'opération de charge C1 d'un premier cycle reconstitué ;
- les segments CD et GH sont mis bout à bout pour former l'opération de décharge D1 du premier cycle reconstitué ;
- le segment FG constitue l'opération de charge C2 d'un deuxième cycle reconstitué et le segment HI constitue l'opération de décharge D2 de ce deuxième cycle reconstitué ;
- le segment BC constitue l'opération de charge C3 d'un troisième cycle reconstitué et le segment DE constitue l'opération de décharge D3 de ce troisième cycle reconstitué

Le premier cycle reconstitué porte l'état de charge de l'accumulateur d'une valeur minimale SOC1 à une valeur maximale SOC4, puis une opération de décharge ramène l'état de charge de cette valeur maximale SOC4 jusqu'à la valeur initiale SOC1. Le deuxième cycle reconstitué porte l'état de charge de la valeur SOC1 jusqu'à une valeur maximale SOC3, puis ramène l'état de charge à la valeur initiale SOC1. Le troisième cycle reconstitué porte l'état de charge de la valeur SOC1 jusqu'à une valeur maximale SOC2, puis ramène l'état de charge à la valeur initiale SOC1.

Dans l'illustration de la figure 2, les cycles reconstitués sont symétriques, bien que la symétrie de ces cycles ne soit pas une obligation pour la mise en oeuvre du procédé, dont la seule donnée impérative est la connaissance de plusieurs opérations de décharge.

Cependant, afin d'estimer l'état de santé, il est préférable d'utiliser les phases de décharge de cycles symétriques ou de cycles reconstitués symétriques au lieu des phases de décharge de n'importe quel cycle. Cette utilisation améliore la précision de l'estimation du fait de l'annulation de l'effet de l'historique d'usage de la batterie sur la valeur estimée. Ainsi, les inventeurs ont montré que les valeurs obtenues de l'état de santé sur une décharge précédée d'une charge de la même amplitude de variation d'état de charge (i.e. cycles symétriques) sont plus précises que celles obtenues à partir d'une phase de décharge précédée d'une charge d'une amplitude de variation d'état de charge différente, par exemple supérieure, à la décharge. Ces avantages sont également obtenus pour les cycles symétriques qui sont reconstitués.

Pour certaines applications, dont les cycles de charge/décharge sont simples et réguliers, un algorithme relativement simple se chargera de cette conversion comme illustré aux figures 1 et 2. Cependant de nombreuses applications sont relatives à des cycles de charge de décharge complexes et irréguliers. Dans ce cas, des algorithmes plus sophistiqués seront employés pour l'opération de conversion décrite. Dans le présent exemple, une réalisation préférée concerne l'utilisation de la méthode de comptage rainflow, développée à l'origine dans le domaine des matériaux pour des estimations de fatigue cyclique, et qui est aujourd'hui utilisée dans de nombreuses applications où un comportement cyclique peut être observé, notamment dans l'éolien, les machines tournantes, et la charge des batteries.

La méthode de comptage rainflow consiste à associer par paire les minima croissants et les maxima décroissants de la courbe initiale, et peut être mise en oeuvre par de nombreux algorithmes connus.

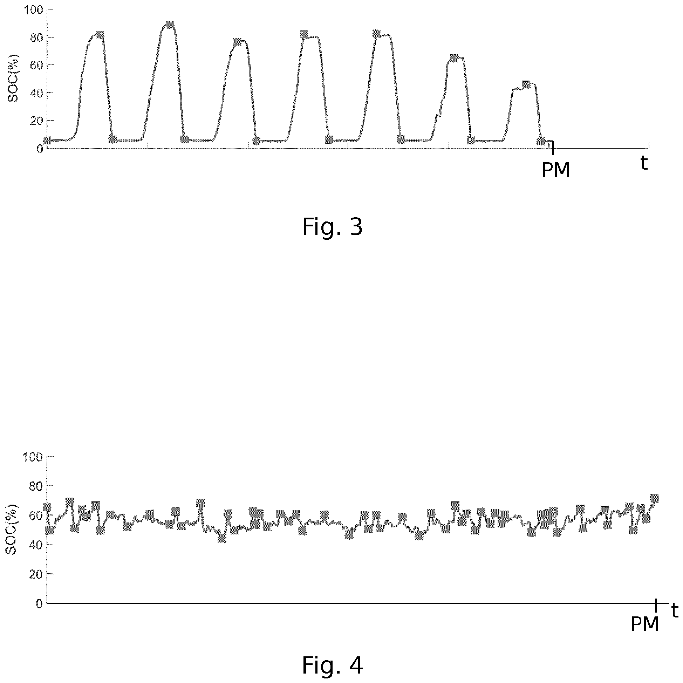

Les figures 3 et 4 illustrent deux exemples réels d'une période de mesure PM comportant un ensemble d'opérations de charge et de décharge pour un accumulateur électrique. La figure 3 illustre un premier profil de charge/décharge d'amplitude assez importante et relativement régulière dans l'ensemble, malgré quelques irrégularités locales. La figure 4 illustre un autre profil de charge/décharge, présentant une amplitude de charge et de décharge plus faible et dont les opérations de charge et de décharge sont très irrégulières.

Pour ces deux profils illustratifs, la mise en oeuvre d'un algorithme implémentant la méthode de comptage de cycle rainflow permettra, dans chaque cas, une conversion efficace en un ensemble équivalent de cycles reconstitués, Sur les figures 3 et 4, les carrés pleins représentent les points d'inflexion qui sont pris en compte pour la création des segments qui formeront les cycles reconstitués. Cette opération est réalisée en associant par paire les minima croissants et les maxima décroissants selon la méthode de comptage « rainflow. ».

À cet effet, il est préférable de pouvoir paramétrer un seuil d'amplitude d'état de charge au-delà duquel une opération de décharge sera prise en compte dans la conversion. Par exemple, un seuil de 1 % entrainera que toute opération de décharge ayant une profondeur de décharge inférieure à 1 %, ne sera pas prise en compte dans l'opération de conversion.

À l'issue de cette étape de conversion, le système de gestion de batterie dispose donc d'un ensemble équivalent de cycles reconstitués , relatifs à la période de mesure.

Le procédé comporte ensuite une étape de filtrage dans laquelle seuls certains cycles reconstitués seront sélectionnés. Le système de gestion de batterie est paramétré avec une valeur prédéterminée d'amplitude d'état de charge au-delà de laquelle un cycle reconstitué sera sélectionné. Dans le présent exemple, cette valeur prédéterminée est supérieure à 5 %, et préférentiellement de 10 %. Autrement dit, seuls les cycles reconstitués dont l'amplitude de charge et de décharge sera supérieure à 10 % seront sélectionnés pour la suite des opérations, les autres cycles étant ignorés. Notons que le procédé selon l'invention permet la prise en compte d'opérations de décharge même de faible amplitude (proches de 10 %), ce qui augmente le spectre des mesures sur lesquelles se base l'estimation de l'état de santé de l'accumulateur, et qui donc augmente la précision de cette estimation.

Le paramétrage du seuil (ici de 1 %) et de la valeur prédéterminée (ici de 10 %) rend le procédé applicable à de nombreux profils de charge et décharge et ne nécessite pas d'avoir accès à une phase particulière telle qu'une tension constante, une phase de repos, etc. Le procédé peut être ainsi appliqué à tous profils mêmes les plus irréguliers et les plus hachés, sans intrusion sur le fonctionnement des cycles de charge et de décharge.

Le procédé comporte ensuite une étape de calcul dans laquelle, pour chaque cycle reconstitué qui a été sélectionné à l'étape précédente, l'énergie totale équivalente pour une charge complète de l'accumulateur est déterminée. L'énergie totale équivalente désigne ici l'énergie totale que la batterie est capable de délivrer après une charge complète, au vu de son comportement durant l'opération de décharge du cycle reconstitué considéré.

Pour ce calcul, le système de gestion de batterie procède à l'intégration de la puissance déchargée de l'accumulateur sur toute la phase de décharge du cycle reconstitué sélectionné considéré. Cette puissance est égale au produit du courant (réel, mesuré sur la période de mesure PM) par la tension de l'accumulateur, (réelle, également mesurée durant la période de mesure PM). Cette intégration se fait pour l'opération de décharge de chacun des cycles reconstitués qui ont été sélectionnés. Dans le cas où les paramètres mesurés sur la période de mesure PM se présentent sous forme d'un ensemble de valeurs discrètes, cette intégration prend la forme d'une somme.

Le résultat de l'intégration est une quantité d'énergie (exprimée par exemple en Wh) relative à un cycle reconstitué. Pour un cycle reconstitué sélectionné noté idx, cette quantité d'énergie correspond à une différence d'état de charge notée :

$SOC_{idis}$ - $SOC_{fdis}$

avec $SOC_{idis}$ qui est l'état de charge initial du cycle reconstitué et $SOC_{fdis}$ qui est l'état de charge final du cycle idx.

En divisant l'intégrale de la puissance (donc de l'énergie) déchargée lors de l'opération de décharge du cycle reconstitué sélectionné (paramètre $DW\,h_{idx}$ dans la formule ci-dessous) par l'amplitude de charge considérée ($SOC_{idis}$ - $SOC_{fdis}$), on obtient le taux d'énergie fournie par l'accumulateur lors de la phase de décharge, par unité d'amplitude d'état de charge. En multipliant cette valeur par 100, on obtient l'énergie totale équivalente pour une charge complète de l'accumulateur.

Ainsi, pour chacun des cycles reconstitués sélectionnés idx, la formule de calcul est ici la suivante :

$$E_{idx} = \frac{DW\,h_{idx}}{SOC_{idis} - SOC_{fdis}} \times 100$$

dans laquelle :

- $E_{idx}$ est l'énergie totale équivalente du cycle reconstitué sélectionné idx ;
- $DW\,h_{idx}$ est l'intégrale de la puissance déchargée lors de l'opération de décharge du cycle reconstitué sélectionné idx ;
- $SOC_{idis}$ est l'état de charge initial lors de l'opération de décharge du cycle reconstitué sélectionné idx ;
- $SOC_{fdis}$ est l'état de charge final lors de l'opération de décharge du cycle reconstitué sélectionné idx.

À ce stade du procédé, nous disposons d'autant de valeurs $E_{idx}$ que de cycles reconstitués sélectionnés sur la période de mesure PM.

Le procédé étant, dans le présent exemple, appliqué à un conteneur formé d'un ensemble de racks qui sont chacun déconnectables, le procédé peut ici comporter une étape facultative permettant d'éviter les variations brusques de l'indicateur d'état de santé qui sera in fine déterminé, en cas de modification du nombre de racks connectés au sein du conteneur et non au vieillissement. Le but est de ne pas imputer une simple déconnexion de rack au sein du conteneur, à un phénomène de vieillissement. Dans ce cas, le calcul de l'état de santé est de préférence basé sur l'énergie à l'échelle des racks, plutôt qu'à l'échelle du conteneur. La valeur de l'énergie totale équivalente pour chaque cycle reconstitué est ainsi divisée par un nombre de sous-ensembles déconnectables (ici les racks) qui constituent l'accumulateur électrique (ici le conteneur).

Ainsi, pour chaque cycle reconstitué sélectionné idx, l'énergie $E_{idx}$ précédemment calculée est ensuite divisée par le nombre de racks disponibles à la fin de l'opération de décharge du cycle idx considéré, selon l'équation suivante :

$$E_i = \frac{E_{idx}}{NbR}$$

avec :

- $E_i$ : énergie totale équivalente du cycle reconstitué sélectionné, pour un rack du container ;
- NbR : nombre de racks disponibles (connectés).

Le procédé passe ensuite à une étape visant à déterminer une valeur moyenne à partir des valeurs d'énergie totale équivalente relatives à une pluralité de cycles reconstitués sélectionnés. Selon un premier exemple, cette étape est une simple moyenne calculée à partir de toutes les valeurs $E_i$ (ou des valeurs $E_{idx}$, lorsque l'étape de calcul ramenant à l'énergie par rack n'est pas mise en oeuvre) pour obtenir une valeur moyenne d'énergie totale équivalente relative à tous les cycles reconstitués sélectionnés de la période de mesure.

Selon un deuxième exemple, plus robuste, les valeurs $E_i$ (ou des valeurs $E_{idx}$ lorsque l'étape de calcul ramenant à l'énergie par rack n'est pas mise en oeuvre) sont moyennées par le calcul d'une moyenne olympique glissante sur un certain nombre de valeurs (par exemple 30 valeurs). La moyenne olympique d'une série de donnée est la moyenne des éléments de cette série dont on a supprimé la plus petite et la plus grande donnée, ou dont on a supprimé un pourcentage d'observation aux extrémités inférieures et supérieures de la distribution, de sorte à exclure les observations extrêmes.

Pour cet exemple de moyenne glissante, la période de mesure PM est également glissante, actualisée au fur et à mesure du temps.

Optionnellement, cette étape de moyenne peut être déclenchée seulement pour les valeurs d'énergie idx qui sont dans un intervalle prédéterminé. Dans le présent exemple, la borne supérieure Emax de l'intervalle est la capacité nominale en énergie Enom de l'accumulateur, et la borne inférieure Emin est cette même énergie Enom multipliée par l'état de santé SOH minimal pour la validité du modèle (qui est dépendant du cas d'étude).

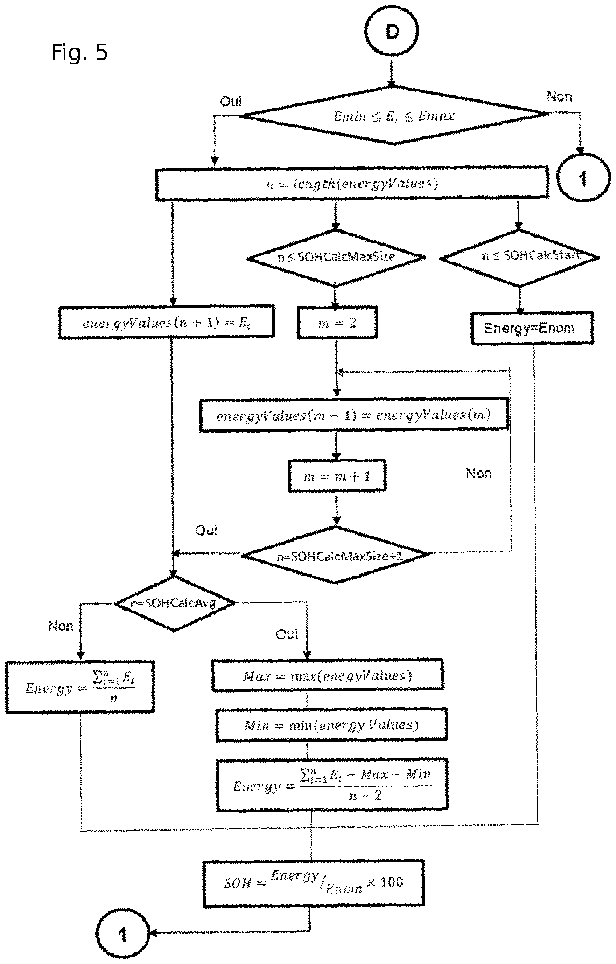

La figure 5 est un exemple illustratif de l'étape de détermination de moyenne, avec moyenne olympique glissante, et intervalle prédéterminé. Sur la figure 5, le D illustre le déclenchement de l'opération de moyenne et l'opération 1 illustre la fin du procédé. Les paramètres illustrés à la figure 5 sont les suivants :

- Energy : la valeur moyenne des valeurs d'énergie totale équivalente relatives à une pluralité de cycles reconstitués sélectionnés ;
- Emin, Emax : bornes de l'intervalle prédéterminé (voir ci-dessus) ;
- $E_i$ : capacité en énergie par rack de l'accumulateur ;
- n = lengh(energyValues) : n correspond au nombre de valeurs d'énergie dont il est question de faire la moyenne ;
- SOHCalcMaxSize : nombre de valeurs d'énergie pour le calcul de la moyenne glissante (ici 30 valeurs) ;
- SOHCalcStart : nombre de valeurs d'énergie à passer avant le calcul du SOH. Si le nombre de valeurs est inférieur à SOHCalcStart, le SOH déterminé est de 100 %. (ici SOHCalcStart=10) ;
- SOHCalcAvg : nombre de valeurs d'énergie avant de faire la moyenne olympique. Tant que la table des énergies contient un nombre de points inférieur ou égal à SOHCalcAvg, on fait une moyenne classique (pas olympique). (ici, SOHCalcAvg=10 à 15).

Une dernière étape (illustrée par la dernière étape de la figure 5) consiste à obtenir la valeur de l'indicateur recherché d'état de santé SOH. Cette valeur est obtenue en divisant la moyenne Energy obtenue précédemment par la valeur de la capacité nominale en énergie de l'accumulateur Enom. Cette opération peut être multipliée par 100 (comme sur la figure 5) pour obtenir l'état de santé SOH exprimé en pourcentage.

L'état de santé SOH est exprimé en termes de perte de capacité à emmagasiner de l'énergie, par rapport à la capacité nominale, de manière actualisée à chaque nouvelle période de mesure (ou de glissement de la période PM) sans intrusion dans le fonctionnement des cycles de charge et de décharge.

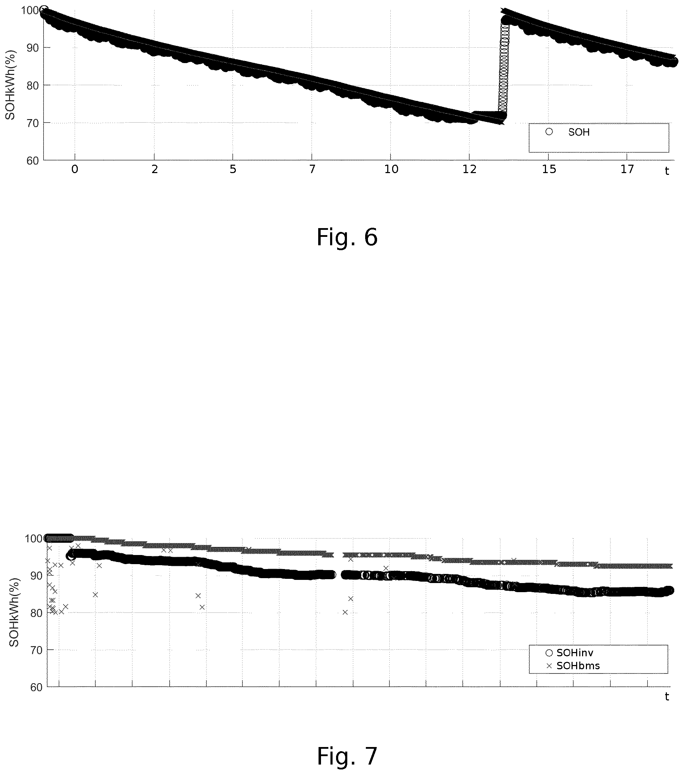

La figure 6 illustre l'application du procédé selon l'invention, avec les variantes de la figure 5, pour déterminer l'évolution de l'état de santé SOH d'un accumulateur (ici un conteneur) sur un très grand nombre de cycles de charge décharge correspondants ici à 17 années d'utilisation. Sur le graphique, l'état de santé SOH démarre ainsi à 100 % lors de l'année zéro (batteries neuves). Au fur et à mesure des cycles de charge et de décharge, l'état de santé de l'accumulateur diminue jusqu'à une valeur de 70 % à l'année 12 (l'accumulateur ne disposant alors plus que de 70 % de sa capacité initiale de stockage en énergie). Après l'année 12, une opération de maintenance conduit à changer les batteries constituant l'accumulateur. Ceci apparaît immédiatement sur le graphique, suivant le procédé décrit, et l'indicateur de l'état de santé se recale à 100 %. Le procédé selon l'invention présente ainsi une forte robustesse lors des changements de batterie, ou autres évènements modifiant la valeur SOH, à la différence de l'art antérieur qui nécessite généralement un paramétrage du système de gestion de batterie lors du remplacement des batteries, et un recalage long à se mettre en place.

La figure 7 illustre une comparaison entre la courbe d'évolution de l'état de santé SOHinv calculé par le procédé selon l'invention, et la courbe d'évolution de l'état de santé SOHbms calculé de manière classique par le système de gestion de batterie, sur une période de mesure correspondant environ à quatre ans d'utilisation.

Les résultats issus du procédé selon l'invention conduisent à une estimation plus juste de l'état de santé, qui est dans cet exemple en dessous de l'état de santé estimé de manière classique, et qui fluctue beaucoup moins, sans points disparates.

**Revendications**

1. Procédé de détermination d'un indicateur d'état de santé (SOH) d'un accumulateur électrique, ce procédé comportant les étapes suivantes :

   - déterminer la capacité nominale en énergie (Enom) de l'accumulateur électrique ;
   - acquérir des mesures de paramètres représentatifs de la tension aux bornes de l'accumulateur électrique, du courant délivré par l'accumulateur électrique, et de l'état de charge (SOC) de l'accumulateur électrique, cette acquisition étant réalisée sur une période de mesure (PM) comportant un ensemble d'opérations de charge et de décharge de l'accumulateur électrique ;

   ce procédé étant **caractérisé en ce qu'**il comporte les étapes suivantes :

   - a) convertir l'ensemble d'opérations de charge et de décharge de la période de mesure (PM) en un ensemble équivalent de cycles reconstitués symétriques, chaque cycle reconstitué symétrique comportant une opération de charge et une opération de décharge de même amplitude d'état de charge ;

- b) sélectionner les cycles reconstitués symétriques dont l'amplitude d'état de charge est supérieure à une valeur prédéterminée ;

- c) pour chaque cycle reconstitué symétrique sélectionné : déterminer le taux d'énergie fournie par l'accumulateur électrique lors de la phase de décharge, par unité d'amplitude d'état de charge de l'accumulateur électrique ; et déterminer une valeur d'énergie totale équivalente pour une charge complète de l'accumulateur électrique ;

- d) déterminer une valeur moyenne à partir des valeurs d'énergie totale équivalente relatives à une pluralité de cycles reconstitués symétriques sélectionnés, et déterminer l'indicateur d'état de santé (SOH) de l'accumulateur électrique en divisant cette valeur moyenne par la valeur de la capacité nominale en énergie (Enom) de l'accumulateur électrique.

2. Procédé selon la revendication 1, **caractérisé en ce que**, à l'étape a), la conversion en cycles reconstitués symétriques est réalisée en associant par paires les minima croissants et les maxima décroissants des opérations de charge et de décharge de la période de mesure.

3. Procédé selon la revendication 2, **caractérisé en ce que**, à l'étape a), la conversion est réalisée par application de la méthode de comptage rainflow.

4. Procédé selon l'une des revendications précédentes, **caractérisé en ce que**, à l'étape c), le taux d'énergie fournie par l'accumulateur électrique lors de la phase de décharge, par unité d'amplitude d'état de charge de l'accumulateur électrique, est déterminé en divisant l'énergie déchargée lors de l'opération de décharge du cycle reconstitué symétrique sélectionné, par l'amplitude de charge du cycle reconstitué symétrique sélectionné.

5. Procédé selon la revendication 4, **caractérisé en ce que**, à l'étape c), la valeur d'énergie totale équivalente d'un cycle reconstitué symétrique sélectionné est déterminée par la formule suivante :

$$E_{idx} = \frac{DW\,h_{idx}}{SOC_{idis} - SOC_{fdis}} \times 100$$

dans laquelle :

- $E_{idx}$ est l'énergie totale équivalente du cycle reconstitué symétrique sélectionné ;
- $DW\,h_{idx}$ est l'intégrale de la puissance déchargée lors de l'opération de décharge du cycle reconstitué symétrique sélectionné ;

- $SOC_{idis}$ est l'état de charge initial lors de l'opération de décharge du cycle reconstitué symétrique sélectionné ;
- $SOC_{fdis}$ est l'état de charge final lors de l'opération de décharge du cycle reconstitué symétrique sélectionné.

6. Procédé selon l'une des revendications précédentes, **caractérisé en ce que** la valeur de l'énergie totale équivalente pour chaque cycle reconstitué symétrique est divisée par un nombre de sous-ensembles déconnectables qui constituent l'accumulateur électrique.

7. Procédé selon l'une des revendications précédentes, **caractérisé en ce que**, à l'étape b), les cycles reconstitués symétriques sélectionnés sont ceux dont l'amplitude de variation de l'état de charge (SOC) ou de la tension est supérieure à une valeur prédéterminée.

8. Procédé selon l'une des revendications précédentes, **caractérisé en ce que**, à l'étape b), ladite valeur prédéterminée est égale à 10 %.

9. Procédé selon l'une des revendications précédentes, **caractérisé en ce que**, à l'étape d), ladite valeur moyenne est déterminée en calculant une moyenne olympique des valeurs d'énergie totale équivalente.

10. Procédé selon l'une des revendications précédentes, **caractérisé en ce que**, à l'étape d), ladite valeur moyenne est une moyenne glissante sur une pluralité de cycles reconstitués symétriques sélectionnés dont la valeur correspondante d'énergie totale équivalente est située dans un intervalle entre un seuil minimal prédéterminé et un seuil maximal prédéterminé.

11. Procédé selon l'une des revendications précédentes, **caractérisé en ce que**, à l'étape d), lesdites valeurs d'énergie totale équivalente relatives à chaque cycle reconstitué symétrique sélectionné comprennent un nombre de valeurs supérieur à une valeur minimale prédéterminée.

12. Procédé selon la revendication 11, **caractérisé en ce que** ladite valeur minimale prédéterminée est de 10.

13. Procédé selon l'une des revendications précédentes, **caractérisé en ce que** la capacité nominale en énergie (Enom) de l'accumulateur électrique est présente en mémoire dans un système de gestion de batterie connecté à l'accumulateur électrique.

14. Procédé selon l'une des revendications 1 à 13, **caractérisé en ce que** la capacité nominale en énergie

(Enom) de l'accumulateur électrique est déterminée par mesure lors d'un premier cycle de charge et de décharge complètes, à la mise en service de l'accumulateur électrique.

15. Procédé selon l'une des revendications précédentes, **caractérisé en ce que** lesdites mesures de paramètres représentatifs de la tension aux bornes de l'accumulateur électrique, du courant délivré par l'accumulateur électrique, et de l'état de charge (SOC) de l'accumulateur électrique, sont réalisées par un système de gestion de batterie connecté à l'accumulateur électrique.

16. Système de gestion de stockage d'énergie électrique, **caractérisé en ce qu'**il est configuré pour mettre en oeuvre le procédé selon l'une des revendications 1 à 15.

17. Produit programme d'ordinateur comprenant des instructions qui conduisent le système de gestion de stockage d'énergie électrique selon la revendication 16 à exécuter les étapes du procédé selon l'une des revendications 1 à 15.

**Patentansprüche**

1. Verfahren zur Bestimmung eines Gesundheitszustandsindikators (SOH) eines elektrischen Akkumulators, wobei dieses Verfahren die folgenden Schritte umfasst:

   - Bestimmen der Nennkapazität an Energie (Enom) des elektrischen Akkumulators;
   - Erfassen der Messungen von Parametern, die für die Spannung an den Klemmen des elektrischen Akkumulators, für den von dem elektrischen Akkumulator abgegebenen Strom und für den Ladezustand (SOC) des elektrischen Akkumulators repräsentativ sind, wobei diese Erfassung über eine Messperiode (PM) ausgeführt wird, die eine Menge von Lade- und Entladevorgängen des elektrischen Akkumulators umfasst;

   wobei dieses Verfahren **dadurch gekennzeichnet ist, dass** es die folgenden Schritte umfasst:

   - a) Umwandeln der Menge von Lade- und Entladevorgängen der Messperiode (PM) in eine äquivalente Menge symmetrischer rekonstruierter Zyklen, wobei jeder symmetrische rekonstruierte Zyklus einen Ladevorgang und einen Entladevorgang mit gleicher Ladezustandsamplitude umfasst;
   - b) Auswählen der symmetrischen rekonstruierten Zyklen, deren Ladezustandsamplitude größer als ein vorbestimmter Wert ist;
   - c) für jeden ausgewählten symmetrischen rekonstruierten Zyklus: Bestimmen der Rate der von dem elektrischen Akkumulator bei der Entladephase ausgegebenen Energie je Ladezustandsamplitudeneinheit des elektrischen Akkumulators; und Bestimmen eines Werts der äquivalenten Gesamtenergie für eine vollständige Ladung des elektrischen Akkumulators;
   - d) Bestimmen eines Mittelwerts ausgehend von den Werten der äquivalenten Gesamtenergie bezüglich einer Vielzahl von ausgewählten symmetrischen rekonstruierten Zyklen, und Bestimmen des Gesundheitszustandsindikators (SOH) des elektrischen Akkumulators, indem dieser Mittelwert durch den Wert der Nennkapazität an Energie (Enom) des elektrischen Akkumulators dividiert wird.

2. Verfahren nach Anspruch 1, **dadurch gekennzeichnet, dass** im Schritt a) die Umwandlung in symmetrische rekonstruierte Zyklen ausgeführt wird, indem die steigenden Minima und die fallenden Maxima der Lade- und Entladevorgänge der Messperiode paarweise zugeordnet werden.

3. Verfahren nach Anspruch 2, **dadurch gekennzeichnet, dass** im Schritt a) die Umwandlung durch Anwenden der Rainflow-Zählmethode ausgeführt wird.

4. Verfahren nach einem der vorhergehenden Ansprüche, **dadurch gekennzeichnet, dass** im Schritt c) die Rate der von dem elektrischen Akkumulator in der Entladephase ausgegebenen Energie je Ladezustandsamplitudeneinheit des elektrischen Akkumulators bestimmt wird, indem die bei dem Entladevorgang des ausgewählten symmetrischen rekonstruierten Zyklus entladene Energie durch die Ladeamplitude des ausgewählten symmetrischen rekonstruierten Zyklus dividiert wird.

5. Verfahren nach Anspruch 4, **dadurch gekennzeichnet, dass** im Schritt c) der Wert der äquivalenten Gesamtenergie eines ausgewählten symmetrischen rekonstruierten Zyklus durch die folgende Formel bestimmt wird:

$$E_{idx} = \frac{DWh_{idx}}{SOC_{idis} - SOC_{fdis}} \times 100$$

worin:

   - $E_{idx}$ die äquivalente Gesamtenergie des ausgewählten symmetrischen rekonstruierten Zyklus ist;
   - $DW\,h_{idx}$ das Integral der entladenen Leistung bei dem Entladevorgang des ausgewählten symmetrischen rekonstruierten Zyklus ist;
- $SOC_{idis}$ der anfängliche Ladezustand bei dem Entladevorgang des ausgewählten symmetrischen rekonstruierten Zyklus ist;
- $SOC_{fdis}$ der finale Ladezustand bei dem Entladevorgang des ausgewählten symmetrischen rekonstruierten Zyklus ist.

6. Verfahren nach einem der vorhergehenden Ansprüche, **dadurch gekennzeichnet, dass** der Wert der äquivalenten Gesamtenergie für jeden symmetrischen rekonstruierten Zyklus durch eine Anzahl von trennbaren Untereinheiten, die den elektrischen Akkumulator bilden, dividiert wird.

7. Verfahren nach einem der vorhergehenden Ansprüche, **dadurch gekennzeichnet, dass** im Schritt b) die ausgewählten symmetrischen rekonstruierten Zyklen diejenigen sind, deren Änderungsamplitude des Ladezustands (SOC) oder der Spannung größer als ein vorbestimmter Wert ist.

8. Verfahren nach einem der vorhergehenden Ansprüche, **dadurch gekennzeichnet, dass** im Schritt b) der vorbestimmte Wert gleich 10 % ist.

9. Verfahren nach einem der vorhergehenden Ansprüche, **dadurch gekennzeichnet, dass** im Schritt d) der Mittelwert bestimmt wird, indem ein olympisches Mittel der Werte der äquivalenten Gesamtenergie berechnet wird.

10. Verfahren nach einem der vorhergehenden Ansprüche, **dadurch gekennzeichnet, dass** im Schritt d) der Mittelwert ein gleitendes Mittel über eine Vielzahl von ausgewählten symmetrischen rekonstruierten Zyklen ist, deren entsprechender Wert der äquivalenten Gesamtenergie in einem Intervall zwischen einem vorbestimmten minimalen Schwellenwert und einem vorbestimmten maximalen Schwellenwert liegt.

11. Verfahren nach einem der vorhergehenden Ansprüche, **dadurch gekennzeichnet, dass** im Schritt d) die Werte der äquivalenten Gesamtenergie bezüglich jedes ausgewählten symmetrischen rekonstruierten Zyklus eine Anzahl von Werten umfassen, die größer als ein vorbestimmter Mindestwert ist.

12. Verfahren nach Anspruch 11, **dadurch gekennzeichnet, dass** der vorbestimmte Mindestwert 10 ist.

13. Verfahren nach einem der vorhergehenden Ansprüche, **dadurch gekennzeichnet, dass** die Nennkapazität an Energie (Enom) des elektrischen Akkumulators im Speicher in einem an den elektrischen Akkumulator angeschlossenen Batteriemanagementsystem vorhanden ist.

14. Verfahren nach einem der Ansprüche 1 bis 13, **dadurch gekennzeichnet, dass** die Nennkapazität an Energie (Enom) des elektrischen Akkumulators durch Messen bei einem ersten Zyklus des vollständigen Ladens und Entladens bei der Inbetriebnahme des elektrischen Akkumulators bestimmt wird.

15. Verfahren nach einem der vorhergehenden Ansprüche, **dadurch gekennzeichnet, dass** die Messungen von Parametern, die für die Spannung an den Klemmen des elektrischen Akkumulators, für den von dem elektrischen Akkumulator abgegebenen Strom und für den Ladezustand (SOC) des elektrischen Akkumulators repräsentativ sind, von einem an den elektrischen Akkumulator angeschlossenen Batteriemanagementsystem ausgeführt werden.

16. Managementsystem für die Speicherung elektrischer Energie, **dadurch gekennzeichnet, dass** es dazu ausgestaltet ist, das Verfahren nach einem der Ansprüche 1 bis 15 durchzuführen.

17. Computerprogrammprodukt mit Anweisungen, die das Managementsystem für die Speicherung elektrischer Energie nach Anspruch 16 veranlassen, die Schritte des Verfahrens nach einem der Ansprüche 1 bis 15 auszuführen.

**Claims**

1. Method for determining a state-of-health (SOH) indicator for an electric accumulator, this method comprising the following steps:

- determining the nominal energy capacity (Enom) of the electric accumulator;
- acquiring measurements of parameters representing the voltage across the terminals of the electric accumulator, the current delivered by the electric accumulator, and the state of charge (SOC) of the electric accumulator, this acquisition being carried out over a measurement period (PM) comprising a set of charging and discharging operations of the electric accumulator;

this method being **characterized in that** it comprises the following steps:

- a) converting the set of charging and discharging operations in the measurement period (PM) into an equivalent set of symmetrical reconstructed cycles, each symmetrical reconstructed cycle comprising one charging operation and one discharging operation having the same state-of-charge amplitude;
- b) selecting the symmetrical reconstructed cycles in which the state-of-charge amplitude is greater than a predetermined value;
- c) for each selected symmetrical reconstructed cycle: determining the rate of energy supplied by the electric accumulator during the discharge phase, by unit of state-of-charge amplitude of the electric accumulator; and determining a total equivalent energy value for a full charge of the electric accumulator;
- d) determining an average value from the total equivalent energy values relating to a plurality of selected symmetrical reconstructed cycles, and determining the state-of-health (SOH) indicator of the electric accumulator by dividing this average value by the nominal energy capacity (Enom) value of the electric accumulator.

2. Method according to Claim 1, **characterized in that**, in step a), the conversion into symmetrical reconstructed cycles is carried out by associating pairs of increasing minima and decreasing maxima of the charging and discharging operations in the measurement period.

3. Method according to Claim 2, **characterized in that**, in step a), the conversion is carried out by applying the rainflow-counting method.

4. Method according to one of the preceding claims, **characterized in that**, in step c), the rate of energy supplied by the electric accumulator during the discharging phase, per unit of state-of-charge amplitude of the electric accumulator, is determined by dividing the energy discharged during the discharging operation of the selected symmetrical reconstructed cycle, by the charge amplitude of the selected symmetrical reconstructed cycle.

5. Method according to Claim 4, **characterized in that**, in step c), the total equivalent energy value of a selected symmetrical reconstructed cycle is determined using the following formula:

$$E_{idx} = \frac{DWh_{idx}}{SOC_{idis} - SOC_{fdis}} \times 100$$

in which:

- $E_{idx}$ is the total equivalent energy of the selected symmetrical reconstructed cycle;
- $DWh_{idx}$ is the integral of the power discharged during the discharging operation of the selected symmetrical reconstructed cycle;
- $SOC_{idis}$ is the initial state of charge during the discharging operation of the selected symmetrical reconstructed cycle;
- $SOC_{fdis}$ is the final state of charge during the discharging operation of the selected symmetrical reconstructed cycle.

6. Method according to one of the preceding claims, **characterized in that** the total equivalent energy value for each symmetrical reconstructed cycle is divided by a number of pluggable sub-units that make up the electric accumulator.

7. Method according to one of the preceding claims, **characterized in that**, in step b), the selected symmetrical reconstructed cycles are those in which the variation amplitude of the state of charge (SOC) or of the voltage is greater than a predetermined value.

8. Method according to one of the preceding claims, **characterized in that**, in step b), said predetermined value is 10%.

9. Method according to one of the preceding claims, **characterized in that**, in step d), said average value is determined by calculating an Olympic average of the total equivalent energy values.

10. Method according to one of the preceding claims, **characterized in that**, in step d), said average value is a moving average over a plurality of selected symmetrical reconstructed cycles in which the corresponding total equivalent energy value falls into a range between a predetermined minimum threshold and a predetermined maximum threshold.

11. Method according to one of the preceding claims, **characterized in that**, in step d), said total equivalent energy values relating to each selected symmetrical reconstructed cycle comprise a number of values greater than a predetermined minimum value.

12. Method according to Claim 11, **characterized in that** said predetermined minimum value is 10.

13. Method according to one of the preceding claims, **characterized in that** the nominal energy capacity (Enom) of the electric accumulator is stored in the memory of a battery management system connected to the electric accumulator.

14. Method according to one of Claims 1 to 13, **characterized in that** the nominal energy capacity (Enom) of the electric accumulator is determined by measurement during a first full charging and discharging cycle, when the electric accumulator is commissioned.

15. Method according to one of the preceding claims, **characterized in that** said measurements of parameters representing the voltage across the terminals of the electric accumulator, the current delivered by the electric accumulator, and the state of charge (SOC) of the electric accumulator, are carried out by a battery management system connected to the electric accumulator.

16. Electric energy storage management system, **characterized in that** it is configured to implement the method according to one of Claims 1 to 15.

17. Computer program product comprising instructions that cause the electric energy storage management system according to Claim 16 to execute the steps of the method according to one of Claims 1 to 15.

Fig. 1

Fig. 2

Fig. 3

Fig. 4

Fig. 5

$Emin \leq E_i \leq Emax$

Oui

Non

$n = length(energyValues)$

1

$n \leq SOHCalcMaxSize$

$n \leq SOHCalcStart$

$energyValues(n + 1) = E_i$

$m = 2$

Energy=Enom

$energyValues(m - 1) = energyValues(m)$

$m = m + 1$

Non

Oui

n=SOHCalcMaxSize+1

n=SOHCalcAvg

Non

Oui

$Energy = \dfrac{\sum_{i=1}^{n} E_i}{n}$

$Max = \max(enegyValues)$

$Min = \min(energy Values)$

$Energy = \dfrac{\sum_{i=1}^{n} E_i - Max - Min}{n - 2}$

$SOH = {Energy}/{Enom} \times 100$

1

Fig. 6

Fig. 7

## RÉFÉRENCES CITÉES DANS LA DESCRIPTION

**Documents brevets cités dans la description**

- DE 102019111976
- US 20080150491 A
- FR 3018608
- EP 3839535 A1

**Littérature non-brevet citée dans la description**

- **HUANG et al.** A Novel Autoregressive Rainflow-Integrated Moving Average Modeling Method for the Accurate State of Health Prédiction of Lithium-Ion Batteries. *Processes,* 2021, vol. 9, 795, https://doi.org/10.3390/pr9050795

- **HUANG et al.** An Improved Rainflow Algorithm Combined with Linear Criterion for the Accurate Li-ion Battery Residual Life. *J. Electrochem. Sci.,* 2021, vol. 16